# EUROPEAN PATENT APPLICATION

(11) **EP 0 840 372 A2**
(43) Date of publication of application: **06.05.1998**
(21) Application number: 97500170.2
(22) Date of filing: 09.10.1997
(51) Int. Cl.: H01L 23/367

(54) **Thermal dissipation system in 800 micrometer printed circuit**

(30) Priority: 29.10.1996 ES 9602287
(71) Applicant: MECANISMOS AUXILIARES INDUSTRIALES S.A. M.A.I.S.A., E-43800 Valls, Tarragona (ES)
(72) Inventor: Aragones Carrete, Alberto, 43800 Valls (Tarragona) (ES)
(74) Representative: Morgades Manonelles, Juan Antonio

(57) **Abstract**

As can be seen in the only Figure attached, it has been totally dispensed with the earlier named radiators, through the means of using the power printed circuit (11) itself as an element of support and electric connection, not only of the electric and electronic components 8149, but at the same time and in a calculated way, as an element for the heat dissipation, using for that the transmitting capacity of the conducting part of said circuit (11).

## Description

The present application of a Patent of Invention consists, as indicated by its title, in a "THERMAL DISSIPATION SYSTEM IN 800 MICRON PRINTED CIRCUIT" which novel characteristics of construction, conformation and design, fullfill the purpose for which it has been specifically projected with a maximum of safety end efficiency.

The innovations that power electronics are offering to the market make foreseable the progressive substitution of conventional mechanic relays for electronic relays in solid state.

This type of devices use a printed circuit of 35 or 70 micron of copper thickness as a support for the connection to the remainder of the electronic components and output connectors.

Also these same devices produce heat when an electric current circulates through same, therefore it's necessary using a dissipation element, that generally consists in an aluminium radiator. Anyhow, this dissipator has a great volume, whith a bad behaviour under vibration and being difficult to mount automatically.

From the Patent of Invention No. 9 501 610 for "ELECTRONIC INTEGRATION IN SERVICE BOXES" was disclosed an electronic function's integration or divided modulus in the interior of an automobile, placing same inside such a box, all that through different integration and interconnection architectures between the signal circuits and the power circuits.

By signal circuits there are understood the printed circuit plates prepared to withstand power intensities lesser than five amperes, having a copper conducting element of 35 to 105 micron, and specially designed for generally housing the automobile's electronics. Whilst the power circuits, capable of supporting up to 400 amperes, are formed with printed circuit plates with a thickness of the conducting element up to 800 micron, in order to be able of conducting important loads towards the automobile's interior.

The architectures and integration advised in said Patent and disclosed in same, had, between other advantages, the fact of using the power printed circuit technology of 400 micron and hybrid signal and power circuits with the subsequent advantage of lesser weight and volume, minor costs, ease of mounting of the box on the vehicle, reduction in the number of connectors and wiring and avoiding mounting errors because of the reduction of the number of references integrated.

Future service boxes with electronic integration must be developed with the capability of including solid state relays mainly because of three reasons.
- it's possible to reduce noticeably the size, as has been earlier recited;
- allow the reduction of the number of electronic components (drivers) or solid state relays, being these integrated in the device;
- display a high reliability because of having neither elements nor contacts of the mechanic type.

The technology that uses the service box with electronic integration, as has already been commented in conection with the Patent No. 9 501 016, is a power printed circuit with 400 micron copper thickness. Since the copper is an element with much better thermal characteristics than aluminium, because of which is the object of the present invention, it's made use of its thermal capacity for dissipating the heat generated by these components.

Therefore it has been determinated the resitivity and thermal capacity of the printed circuit up to 800 micron as a function of the copper's area used.

Other details and features of the present application of a Patent of Invention will be apparent during the description that follows, in which reference is made to the figure attached to this description in which, somewhat schematically, are represented the preferred details. These details are given as an example, with reference to a possible case of practical incorporation, but are not limited to the details there recited; therefore this description must be considered from an illustrative viewpoint and without any type of limitation.

There follows a detailed relation of the several elements named in the present application of a Patent of Invention; (10) service box (not appearing in the Figure), (11) power printed circuit, (12) dielectric substratum, (13) copper conducting track of up to 800 micron, (14) electronic component, (15) plate, (16) screw, (17) washer, (18) nut, (19) hole, (20) dissipation surface of up to 800 micron.

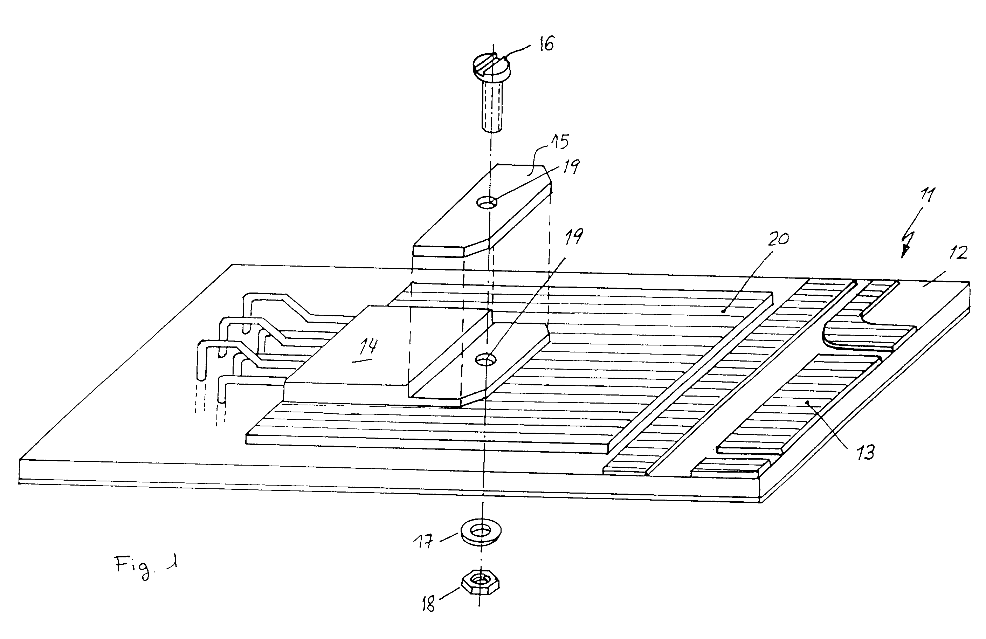

Figure 1 presents schematically an exploded view of power printed circuit (11) in which the figure makes the fiunctions of mechanic and electric support of the component (14), whilst the metal part of the component contacts the copper surface (20) of the printed circuit which performs as thermal radiator.

In a service box of the type disclosed in the Patents of Invention Nos. 9 200 325 and 9 501 610 to the same asignee, are disclosed several forms of service boxes which are not represented in the present invention, and which are formed by the elements there indicated, basically signal circuits, power circuits and hybrid signal and power circuits, combined between them forming several types of architectures and integrating a plurality of electric and electronic elements.In most cases, the electric and electronic devices generate heat and because of that are conventionally used dissipation elements that generally are aluminium radiators, which occupy a sizeable volume and need the corresponding mechanic fixation, making very difficult the automatic mounting in the service boxes production lines (10) for allowing, without too much space occupation, the convective transmission of the heat to the air around the box.

In one of the preferred incorporations of the instant application, and as can be seen in the only Figure attached, the earlier named radiators had been totally eliminated, on the basis of using the power printed circuit (11) itself, no only as a support and electric connection (14) element, but at the same time and in a calculated way as heat dissipation element, using for that the transmission capacity of the conducting part of said circuit (11).

In a way known from earlier patents, a power printed circuit is formed by a dielectric substratum (12) and a conducting copper coat of up to 800 micron.

Over the printed circuit (11) are mounted components of the drivers type, electronic relays or the like (14), what is done -among other methods- with the help of a plate (159 and a conventional screw (16), washer (17) and nut (18), allowing the immobilization of said component (14) in the printed circuit (11).

With the help of the plate (15) the driver (14) is fixed to the circuit (11), in such a way that the conducting part of same , i. e., the coat (20) substitutes the radiator in order to dissipate the heat generated by the component (14), being the surface of the coat (20) a suitable one for the dissipation values necessary, incorporating the element (14) or the like.

The incorporation above disclosed is one of the many examples that may be implemented with the thermal dissipation system disclosed, in which must be taken into account the heat generated by the components (14) or the like in order to determinate the surface (20) using the conducting element, i. e., the copper as a heat transmitter, by which will be obtained the benefits above recited, which basically, besides reducing the size of all elements involved, will increase the reliability in the sense of diminishing the number of electro-mechanic contacts on which normally occur all conductivity mechanic failures detected most frequently on the service boxes (10) detected as deficient.

Described enough what consists the present Invention Patent, corresponding with the attached drawing, it's understood that there may be introduced in same every detail modifications deemed suitable, provided that the variations introduced do not alter the scope of the Patent as claimed in the following claims.

## Claims

1. "THERMAL DISSIPATION SYSTEM IN 800 MICRON PRINTED CIRCUIT" of the type used in service boxes (10) with electronic integration, thanks to including inside of same signal printed circuits of a thickness up to 200 micron, as well as power printed circuits of a thickness up to 800 micron of the copper conductive element, as well as hybrid power and signal circuits all combined with the help of short pins or long pins, as well as welded holes, using in some instances male terminals and female terminals, characterized in that the copper coat (20) of the power printed circuit will perform in the way of a radiator of the electronic elements such as drivers or relays of solid state (14), by the lining up of the elements (14) to the circuit (11) by means of any type of conventional operation.

2. "THERMAL DISSIPATION SYSTEM IN 800 MICRON PRINTED CIRCUIT" characterized as per claim 1 in that the surface of the cooper coat (20) will be a function of the dissipation needs of the heat from the elements (14) placed over the printed circuit (11).
